# EUROPEAN PATENT APPLICATION

(11) **EP 4 832 676 A1**
(43) Date of publication of application: **28.10.2026**
(21) Application number: 25890865.6
(22) Date of filing: 28.08.2025
(51) Int. Cl.: H05K 5/02

(54) **MAIN BOARD ASSEMBLY AND ELECTRONIC DEVICE**

(30) Priority: 18.11.2024 CN 202411664833
(71) Applicant: Huawei Technologies Co., Ltd., Shenzhen, Guangdong 518129 (CN)
(72) Inventor: YE, Mao, Shenzhen, Guangdong 518129 (CN); WANG, Jiaming, Shenzhen, Guangdong 518129 (CN); YU, Dong, Shenzhen, Guangdong 518129 (CN); WANG, Jia, Shenzhen, Guangdong 518129 (CN); CHU, Jiahui, Shenzhen, Guangdong 518129 (CN); KE, Lishun, Shenzhen, Guangdong 518129 (CN); CHEN, Quanshui, Shenzhen, Guangdong 518129 (CN); WANG, Hanyang, Shenzhen, Guangdong 518129 (CN)
(74) Representative: Gill Jennings & Every LLP
(86) International application number: PCT/CN2025/117404
(87) International publication number: WO 2026/103271

(57) **Abstract**

Embodiments of this application provide a mainboard assembly and an electronic device, to resolve a problem of low antenna efficiency. In the electronic device, at least a part of a middle frame is disposed between a battery and a first radiator, an opening is provided in the middle frame, and the first radiator covers at least a part of the opening. The provided opening provides clearance for the first antenna, or a part of a thickness of the middle frame provides clearance for the first antenna, thereby improving a gain of the first antenna.

## Description

This application claims priority to Chinese Patent Application No. 202411664833.8, filed with the China National Intellectual Property Administration on November 18, 2024 and entitled "MAINBOARD ASSEMBLY AND ELECTRONIC DEVICE", which is incorporated herein by reference in its entirety.

### TECHNICAL FIELD

Embodiments of this application relate to the field of communications technologies, and specifically, to a mainboard assembly and an electronic device.

### BACKGROUND

An electronic device (for example, a mobile phone or a tablet computer) generally has an antenna. The antenna is disposed inside the electronic device, and a radiator of the antenna and a ground structure (for example, a battery or a middle frame) in the electronic device are spaced apart from each other. However, a thickness of the electronic device is limited, and a distance between the radiator and the ground structure is relatively small. This results in low antenna efficiency.

### SUMMARY

Embodiments of this application provide a mainboard assembly and an electronic device, to improve antenna efficiency.

According to a first aspect, an embodiment of this application provides an electronic device. The electronic device includes a battery, a middle frame, a housing, and a first antenna, where the battery, the middle frame, and the first antenna are disposed in the housing, at least a part of the middle frame is disposed between the battery and a first radiator of the first antenna, an opening is provided in the middle frame and runs through the middle frame, the first radiator covers at least a part of the opening, and the first radiator is located between the opening and an insulation part of the housing.

According to the foregoing disposing, at least a part of the middle frame is disposed between the battery and the first radiator, the opening is provided in the middle frame, and the first radiator covers at least a part of the opening. The provided opening provides clearance for the first antenna, or a part of a thickness of the middle frame provides clearance for the first antenna, thereby improving a gain of the first antenna.

In some embodiments that may include the foregoing embodiments, the electronic device further includes a mainboard, the middle frame includes a first surface and a second surface that are disposed opposite to each other, the first surface is provided with a first groove, the mainboard is disposed in the first groove, the second surface is provided with a second groove, the battery is disposed in the second groove, projections of the first groove and the second groove on the middle frame are spaced apart from each other, the mainboard has a feed, and the feed is coupled to the first radiator.

In this way, the mainboard is disposed in the first groove of the middle frame, the battery is disposed in the second groove of the middle frame, and at least a part of the first radiator coupled to the feed of the mainboard covers the opening in the middle frame. The thickness of the middle frame is used to provide clearance for the antenna, and the radiator of the antenna does not need to be raised inside the housing to obtain clearance, thereby reducing a thickness of the electronic device. In some embodiments that may include the foregoing embodiments, a part of the first radiator is located on a side that is of the mainboard and that is away from the middle frame, a feed member is disposed on the mainboard, and the feed is coupled to the first radiator by using the feed member. In this way, the first radiator may be fed without a complex feeding structure. For example, the feed member may include a structure such as a contact spring and a capacitor, so as to be coupled to and feed the first radiator by using the feed member. In an implementation in which an antenna support is disposed on the mainboard, the antenna support is an insulation support, and the first radiator may be fastened on the mainboard by using the antenna support. Correspondingly, the feed member may include a conductor (such as a conductive line or a conductive plate) disposed on the antenna support, to be coupled to and feed the first radiator by using the feed member.

In some embodiments that may include the foregoing embodiments, the first radiator extends along a surface of the mainboard, and a part that is of the first radiator and that extends outside the mainboard, to cover an opening in the middle frame. It may be understood that, when the mainboard assembly is not installed on the middle frame, the first radiator may have an included angle with the mainboard, or may be approximately parallel to the mainboard. After the mainboard assembly is installed on the middle frame, the first radiator is approximately parallel to the mainboard, to cover the opening. That the part of the first radiator extends outside the mainboard may be understood as that a projection of the part of the first radiator on a display panel extends outside a projection of the mainboard on the display panel.

In some embodiments that may include the foregoing embodiments, the opening is filled with a dielectric layer. In this way, the dielectric layer supports the first radiator corresponding to the opening, to avoid deformation of the first radiator. In an embodiment, a dielectric constant in the opening may be further adjusted by using the dielectric layer, to further adjust performance of the first antenna.

In some embodiments that may include the foregoing embodiments, a gap is provided on the first radiator, and the gap truncates the first radiator in a width direction of the first radiator. In this way, an electrical length of the first radiator may be adjusted by using the gap, to adjust a communication frequency band covered by the first antenna; or a radiation aperture of the first antenna is expanded in a same communication frequency band, to improve radiation efficiency of the first antenna.

In some embodiments that may include the foregoing embodiments, there are a plurality of gaps, and the plurality of gaps are spaced apart in a length direction of the first radiator. In this way, the electrical length of the first radiator may be further adjusted. In a case of a same electrical length, a larger quantity of gaps are provided, so that an aperture of the first antenna may be increased, and the radiation efficiency of the first antenna may be improved. In addition, a proper position of the gap may be set to avoid another structure in the electronic device, to prevent the first radiator from affecting disposing and working of the another structure in the electronic device, thereby increasing a degree of freedom of antenna design.

In some embodiments that may include the foregoing embodiments, the middle frame further includes a connection rib, and the connection rib is disposed in the opening. The opening reduces structural strength of the middle frame, and disposing the connection rib may improve structural strength of the middle frame, thereby avoiding deformation of the middle frame. It may be understood that the connection rib is disposed in the opening, the connection rib may divide the opening into a first opening and a second opening, and the first opening and the second opening may be arranged roughly along the length direction of the first radiator.

In some embodiments that may include the foregoing embodiments, both ends of the radiator in the length direction are open ends, and in the length direction, a distance between the connection rib and a midpoint of the radiator is less than or equal to a quarter of a size of the radiator in the length direction.

In this way, the connection rib may correspond to a middle part of the first radiator, and the middle part of the first radiator is generally a current antinode. In other words, a current in the middle part is large. Disposing the connection rib in the middle part may reduce impact of the connection rib on the first radiator, thereby ensuring that the first antenna has high efficiency.

In some embodiments that may include the foregoing embodiments, the electronic device further includes a side frame, the side frame is disposed around an outer periphery of the middle frame, the side frame includes a first side frame and a second side frame that are adjacent to each other, the first side frame and the second side frame are disposed vertically, and a length of the first side frame is less than a length of the second side frame; and the mainboard and the battery are arranged in a length direction of the second side frame. Because the first radiator is located at a boundary position between the mainboard and the battery, the first radiator may be located in a middle area in a length direction (a direction parallel to the second side frame) of the electronic device. In this way, when a user holds the electronic device in landscape mode, it is not likely for a hand of the user to block the first radiator, to avoid affecting performance (for example, a gain of the first antenna) of the first antenna.

It may be understood that the landscape mode may be a scenario in which the user uses a mobile phone to play a game, watch a video, or the like. In the horizontal placement scenario, the second side frame is approximately parallel to a horizontal plane, and the user generally holds the first side frame and an area near the first side frame. In other words, the user holds two ends of the electronic device in the length direction. However, the first radiator is located at a boundary position between the mainboard and the battery, so that the first radiator may be prevented from being blocked in the landscape mode.

In some embodiments that may include the foregoing embodiments, the electronic device further includes a sub-board, where the sub-board is disposed in accommodation space, the sub-board is disposed on the middle frame, the mainboard, the battery, and the sub-board are arranged along the length direction of the second side frame, and the battery is located between the mainboard and the sub-board. In this way, the first radiator may still be located in the middle area in the length direction of the electronic device. When the user holds the electronic device in landscape mode, it is not likely for a hand of the user to block the first radiator, to avoid affecting the performance of the first antenna.

In portrait mode (for example, making or receiving a phone call, browsing a web page, or receiving or sending a video), the second side frame is approximately perpendicular to a horizontal plane, the first side frame may be located on the top of the electronic device, the mainboard may be disposed close to the first side frame, that is, the mainboard is located at an upper part of the electronic device, the sub-board is located at a lower part of the electronic device, and the first radiator is located at a boundary position between the mainboard and the battery, so that the first radiator is located at an upper half of the electronic device. However, in the portrait mode, a hand of the user generally holds a lower half of the electronic device, and the hand of the user does not hold the first radiator, to prevent the hand of the user from affecting performance of the first antenna.

In some embodiments that may include the foregoing embodiments, the sub-board may include a printed circuit board, components such as a speaker and a microphone may be disposed on the sub-board, and the sub-board is electrically connected to the mainboard, to work under the control of a processor.

In some embodiments that may include the foregoing embodiments, the sub-board and the mainboard may be located on a same side of the middle frame. Correspondingly, the first surface of the middle frame is further provided with a third groove, and the sub-board is disposed in the third groove, to facilitate installation and maintenance of the mainboard and the sub-board. Certainly, the sub-board and the battery may alternatively be located on a same side of the middle frame. Correspondingly, the third groove may be disposed on the second surface of the mainboard, and the sub-board is disposed in the third groove.

In some embodiments that may include the foregoing embodiments, the electronic device further includes a second antenna and a switch apparatus, a second radiator of the second antenna is disposed in the first side frame, the switch apparatus is coupled to both the first radiator and the second radiator, and the switch apparatus is configured to switch a working status of the first antenna and/or a working status of the second antenna. For example, the switch apparatus may enable the first antenna to be in a working state, and enable the second antenna to be in a power-off state (not working), and in this case, the first antenna is used to receive or send a signal; or the switch apparatus may enable the first antenna to be in a power-off state, and enable the second antenna to be in a working state, and in this case, the second antenna is used to receive or send a signal.

For example, a communication frequency band of the first antenna and a communication frequency band of the second antenna may be at least partially the same, and the first antenna and the second antenna may receive or send a same signal. For example, both the first antenna and the second antenna may be configured to receive or send a cellular signal or a Wi-Fi signal. Signals received and sent by the first antenna and the second antenna are not limited in this embodiment of this application.

According to the foregoing disposing, the switch apparatus may select one of the first antenna and the second antenna with better performance to receive or send a signal, to ensure communication quality of the electronic device. It may be understood that, in landscape mode, the user holds the electronic device near the first side frame, and a hand of the user blocks the second radiator. Consequently, signal receiving and sending of the second radiator are affected. In this case, the switch apparatus may control the first antenna to be in a working state, and control the second antenna to be in a power-off state, and the first radiator is used to receive or send a signal, so that relatively good communication quality can be ensured. In the portrait mode, the first side frame generally faces a zenith direction. In this case, the switch apparatus may be used to control the first radiator to be in a power-off state, and control the second radiator to be in a working state, to receive or send a signal by using the second radiator, to ensure relatively good communication quality. In other words, it may be ensured that the electronic device has relatively good communication quality in each application scenario.

In some embodiments that may include the foregoing embodiments, the electronic device further includes a second antenna, a second radiator of the second antenna is disposed on the second side frame, and the first antenna and the second antenna have a same communication frequency band. The first antenna and the second antenna may separately transmit and receive signals, to form a multiple-input multiple-output (Multiple-Input Multiple-Output, MIMO for short) system, thereby improving communication performance.

In some embodiments that may include the foregoing embodiments, a minimum distance between the first radiator and the second radiator is less than or equal to 10 mm, to ensure compactness of a structure.

In some embodiments that may include the foregoing embodiments, there is a part of the middle frame between the first radiator and the second radiator, and the middle frame is generally grounded. The part of the middle frame may improve isolation between the first radiator and the second radiator, to ensure antenna radiation efficiency of the first antenna and the second antenna.

In some embodiments that may include the foregoing embodiments, the first radiator is configured to generate a first resonance and a second resonance, and a resonance frequency of the first resonance is less than a resonance frequency of the second resonance. In this way, the first radiator is configured to generate two resonances, so that a bandwidth of the first antenna may be increased, thereby improving performance of the first antenna. For example, the first resonance and the second resonance may cover a same communication frequency band, or the first resonance and the second resonance separately cover different communication frequency bands. This is not limited in this embodiment of this application.

In some embodiments that may include the foregoing embodiments, under the first resonance, a current on the first radiator is a co-directional current. Correspondingly, both system efficiency and radiation efficiency of the first antenna are high. A radiation pattern is mainly radiated from a back cover to a direction away from the display panel, and the radiation pattern is approximately hemispherical. Under the second resonance, currents on the first radiator on two sides of the gap are reverse currents. In this case, the first antenna still has specific system efficiency and radiation efficiency, and the radiation pattern is in a lobe shape on a side that is of the back cover and that is away from the display panel (a main lobe and a side lobe of the radiation pattern are spaced apart from each other along the length direction of the electronic device) and radiates in a direction away from the display panel. It may be learned that both the first resonance and the second resonance can meet a communication requirement, so that the first antenna has a large bandwidth.

In some embodiments that may include the foregoing embodiments, the first radiator includes a first sub-radiator and a second sub-radiator, the first sub-radiator and the second sub-radiator each cover a part of the opening, the first sub-radiator and the second sub-radiator are spaced apart from each other in a direction parallel to the middle frame, a first feed point is disposed on the first sub-radiator, and the first sub-radiator is configured to be coupled to and feed the second sub-radiator.

In this way, an area of the first radiator may be increased, so that more resonance modes may be formed (for example, a third resonance is formed, and a resonance frequency of the third resonance may be greater than the resonance frequency of the second resonance; or a resonance frequency of the third resonance is less than the resonance frequency of the first resonance), and the bandwidth of the first antenna may be further increased.

In some embodiments that may include the foregoing embodiments, the first radiator includes a first sub-radiator and a second sub-radiator, the first sub-radiator and the second sub-radiator each cover a part of the opening, the first sub-radiator and the second sub-radiator are spaced apart from each other in a direction parallel to the middle frame, a first feed point is disposed on the first sub-radiator, a second feed point is disposed on the second sub-radiator, the first sub-radiator is configured to generate a first resonance, the second sub-radiator is configured to generate a second resonance, and a resonance frequency of the first resonance is staggered from a resonance frequency of the second resonance.

In this way, different resonances may be formed by using different feed points, so that the bandwidth of the first antenna may be increased, or different communication frequency bands may be covered.

In some embodiments that may include the foregoing embodiments, the housing includes a display panel and a back cover, and the display panel and the back cover are disposed on two sides of the middle frame; and the mainboard and the first radiator are both located between the middle frame and the back cover, and the battery is located between the middle frame and the display panel. In this way, disassembling and maintenance of the mainboard may be implemented by removing the back cover, which facilitates disassembling and maintenance of the mainboard.

In some embodiments that may include the foregoing embodiments, the housing includes a display panel and a back cover, and the display panel and the back cover are disposed on two sides of the middle frame; and the first radiator is located between the middle frame and the back cover, and the battery and the mainboard are both located between the middle frame and the display panel. In this way, disassembling and maintenance of the battery and the mainboard may be implemented by removing the back cover, which facilitates disassembling and maintenance of the battery and the mainboard.

In some embodiments that may include the foregoing embodiments, the housing includes a display panel and a back cover, the display panel and the back cover are both disposed on the middle frame, the first radiator is located between the display panel and the middle frame, and the battery is located between the middle frame and the back cover. In this way, disassembling and maintenance of the battery may be implemented by removing the back cover, which facilitates disassembling and maintenance of the battery.

According to a second aspect, an embodiment of this application further provides a mainboard assembly. The mainboard assembly includes a mainboard and a first antenna, where a feed member is disposed on the mainboard, one end of a first radiator of the first antenna is coupled to the feed member, the feed member is configured to be coupled to and feed the first radiator, the first radiator extends along a surface of the mainboard, and a part that is of the first radiator and that extends outside the mainboard.

In this way, interference caused by a component on the mainboard to the first radiator may be reduced, and communication quality may be improved.

In some embodiments that may include the foregoing embodiments, the part that is of the first radiator and that extends outside the mainboard is configured to cover an opening of a middle frame of an electronic device.

According to the foregoing disposing, the middle frame is disposed between a battery and the first radiator, the opening is provided in the middle frame, and the first radiator covers at least a part of the opening. The provided opening provides clearance for the first antenna, or a part of a thickness of the middle frame provides clearance for the first antenna, thereby improving a gain of the first antenna.

In some embodiments that may include the foregoing embodiments, a gap is provided on the first radiator, and the gap truncates the first radiator in a width direction of the first radiator. In this way, an electrical length of the first radiator may be adjusted by using the gap, to adjust a communication frequency band covered by the first antenna; or a radiation aperture of the first antenna is expanded in a same communication frequency band, to improve radiation efficiency of the first antenna.

In some embodiments that may include the foregoing embodiments, there are a plurality of gaps, and the plurality of gaps are spaced apart in a length direction of the first radiator. In this way, the electrical length of the first radiator may be further adjusted. In a case of a same electrical length, a larger quantity of gaps are provided, so that a length of the first radiator may be reduced, thereby facilitating miniaturization. In addition, providing a plurality of gaps may increase an aperture of the first antenna, and improve radiation efficiency of the first antenna. In addition, a proper position of the gap may be set to avoid another structure in the electronic device, to prevent the first radiator from affecting disposing and working of the another structure in the electronic device.

In some embodiments that may include the foregoing embodiments, the mainboard assembly further includes a flexible substrate, the first radiator is disposed on the flexible substrate, and one end of the flexible substrate is connected to the mainboard. In this way, the first radiator may be supported by using the flexible substrate. It may be understood that the first radiator has a relatively small thickness, and the flexible substrate may support the first radiator, to avoid damage to or deformation of the first radiator in a process of installing and moving the mainboard assembly.

### BRIEF DESCRIPTION OF DRAWINGS

FIG. 1 is an exploded view of an electronic device according to an embodiment of this application;
FIG. 2 is an exploded view of a mainboard assembly and a middle frame in an electronic device according to an embodiment of this application;
FIG. 3 is a diagram of a structure of a mainboard assembly according to an embodiment of this application;
FIG. 4 is a sectional view 1 of an electronic device according to an embodiment of this application;
FIG. 5 is a diagram of an electronic device in portrait mode according to an embodiment of this application;
FIG. 6 is a diagram of assembly of a first radiator in an electronic device according to an embodiment of this application;
FIG. 7 is a sectional view 2 of an electronic device according to an embodiment of this application;
FIG. 8 is a diagram of an electronic device in landscape mode according to an embodiment of this application;
FIG. 9 is a diagram of a structure of a dielectric layer disposed in an electronic device according to an embodiment of this application;
FIG. 10 is a curve diagram of a return loss of a first antenna shown in FIG. 9;
FIG. 11 is a diagram of a structure of a plurality of gaps provided on a first radiator in an electronic device according to an embodiment of this application;
FIG. 12 is a curve diagram of a return loss of a first antenna shown in FIG. 11;
FIG. 13 is a diagram of a structure of a connection rib disposed in an electronic device according to an embodiment of this application;
FIG. 14 is a curve diagram of a return loss of a first antenna shown in FIG. 13;
FIG. 15 is a diagram 1 of a structure of a second radiator disposed in an electronic device according to an embodiment of this application;
FIG. 16 is a diagram 2 of a structure of a second radiator disposed in an electronic device according to an embodiment of this application;
FIG. 17 is a diagram of S-curves for a first antenna and a second antenna shown in FIG. 16;
FIG. 18 is a diagram 1 of a structure of a first radiator in an electronic device according to an embodiment of this application; and
FIG. 19 is a diagram 2 of a structure of a first radiator in an electronic device according to an embodiment of this application.

Reference numerals: 10: middle frame: 11: opening; 12: first groove; 13: second groove; 14: third groove; 15: dielectric layer; 16: connection rib; 17: positioning pin; 20: mainboard assembly; 21: mainboard; 22: first radiator; 23: gap; 24: switch apparatus; 25: antenna support; 30: battery; 40: display panel; 50: back cover; 60: sub-board; 100: electronic device; 101: mainboard assembly; 102: first surface; 103: second surface; 110: side frame; 111: first side frame; 112: second side frame; 113: second radiator; 221: first sub-radiator; 222: second sub-radiator.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms "first" and "second" mentioned below are merely intended for a purpose of description, and shall not be understood as an indication or implication of relative importance or implicit indication of the quantity of indicated technical features. Therefore, a feature defined by "first", "second", or the like may explicitly or implicitly include one or more features.

In addition, in embodiments of this application, orientation terms such as "above", "below", "left", "right", "horizontal", and "vertical" are defined relative to placement orientations of components shown in the accompanying drawings. It should be understood that these directional terms are relative concepts that are used for relative description and clarification, and may vary correspondingly based on changes in the placement orientations of the components in the accompanying drawings.

The following describes terms that may appear in embodiments of this application.

Connection/joining: It should be understood in a broad sense. For example, the "connection" may be a fixed connection, an electrical connection, a detachable connection, or an integral connection, or may be a direct connection, or may be an indirect connection through an intermediate medium.

Coupling: The coupling may be understood as direct coupling and/or indirect coupling, and a "coupling connection" may be understood as a direct coupling connection and/or an indirect coupling connection. The direct coupling may also be referred to as an "electrical connection", which may be understood as physical contact and electrical conduction of components, or may be understood as a form of connection between different components in a line structure through a physical line that can transmit an electrical signal, for example, a printed circuit board (printed circuit board, PCB for short) copper foil or a conducting wire. The "indirect coupling" may be understood as electrical conduction of two conductors through an air gap or in a non-contact manner. In an embodiment, the indirect coupling may also be referred to as capacitive coupling. For example, signal transmission is implemented by forming an equivalent capacitor through coupling in a gap between two spaced conductive members.

Opposite/disposed opposite to each other: That A is disposed opposite to B may mean that A and B are disposed opposite to each other or face to face (opposite to, or face to face). For example, when two radiators are disposed opposite to each other, at least some areas of the two radiators overlap in a direction. In an embodiment, two radiators disposed opposite to each other are adjacently disposed, no other radiator is disposed between the two radiators, and no conductor other than an antenna structure is disposed between the two radiators.

Lumped element/component: The lumped element/component is a general name of all elements whose sizes are far less than a wavelength corresponding to an operating frequency of a circuit. For a signal, a characteristic of the element is constant at any time, regardless of a frequency.

Distributed element/component: A difference between the distributed element and a lumped element lies in that if dimensions of an element are close to or greater than a wavelength corresponding to an operating frequency of a circuit, a characteristic of each point of the element varies with a signal when the signal passes through the element. In this case, the element cannot be considered as a single entity with a constant characteristic, but needs to be referred to as a distributed element.

Capacitor/capacitor structure: The capacitor/capacitor structure may be understood as a lumped capacitor and/or a distributed capacitor. The lumped capacitor is a capacitive component, for example, a capacitive element. The distributed capacitor (or a distributed type capacitor) is an equivalent capacitor formed by two conductive members that are spaced apart by a specific gap.

Inductor/inductor structure: The inductor/inductor structure may be understood as a lumped inductor and/or a distributed inductor. The lumped inductor is an inductive component, for example, an inductive element. The distributed inductor (or a distributed type inductor) is an equivalent inductor formed by a conductive member of a specific length, for example, an equivalent inductor formed by a conductor due to bending or rotation.

Radiator or antenna stub: The radiator or antenna stub is an apparatus configured to receive/send electromagnetic wave radiation in an antenna. In some cases, an "antenna" is understood as a radiator in a narrow sense. The antenna converts guided wave energy from a transmitter into a radio wave, or converts a radio wave into guided wave energy to radiate and receive a radio wave. Modulated high-frequency current energy (or guided wave energy) generated by the transmitter is transmitted to a transmit radiator through a feeder. The radiator converts the energy into specific polarized electromagnetic wave energy and radiates the energy in a required direction. A receive radiator converts specific polarized electromagnetic wave energy from a specific direction of space into modulated high-frequency current energy, and transmits the modulated high-frequency current energy to an input end of a receiver through a feeder.

The radiator (or antenna stub) may include a conductor having a specific shape and size, for example, a linear conductor or a sheet conductor. A specific shape is not limited in this application. In an embodiment, the linear radiator may be briefly referred to as a wire antenna. In an embodiment, the linear radiator may be implemented by a conductive side frame, and may also be referred to as a side frame antenna. In an embodiment, the linear radiator may be implemented by a bracketed conductor, and may also be referred to as a bracketed antenna. In an embodiment, a wire diameter (for example, including a thickness and a width) of the linear radiator or a radiator of the wire antenna is far less than a wavelength (for example, a medium wavelength) (for example, is less than 1/16 of the wavelength), and a length may be compared with the wavelength (for example, the medium wavelength) (for example, the length is approximately 1/8 of the wavelength, or 1/8 to 1/4 of the wavelength, or 1/4 to 1/2 of the wavelength, or greater). Main forms of the wire antenna include the following: a dipole antenna, a half-wave dipole antenna, a monopole antenna, a loop antenna, and an inverted F antenna (also referred to as an IFA, Inverted F Antenna). For example, for the dipole antenna, each dipole antenna usually includes two radiation stubs, and each stub is fed by a feed portion from a feed end of the radiation stub. For example, the inverted F antenna (Inverted F Antenna, IFA) may be considered as being obtained by adding a grounding path to a monopole antenna. The IFA has a feed point and a grounding point, and is referred to as the inverted F antenna because a side view of the IFA is in an inverted F shape. In an embodiment, the sheet-shaped radiator may include a microstrip antenna or a patch (patch) antenna, for example, a planar inverted F antenna (also referred to as a PIFA, Planar Inverted F Antenna). In an embodiment, the sheet-shaped radiator may be implemented by a planar conductor (for example, a conductive sheet or a conductive coating). In an embodiment, the sheet-shaped radiator may include a conductive sheet, for example, a copper sheet. In an embodiment, the sheet-shaped radiator may include a conductive coating, for example, silver paste. A shape of the sheet-shaped radiator includes a circular shape, a rectangular shape, a ring shape, and the like. A specific shape is not limited in this application. A structure of the microstrip antenna usually includes a dielectric substrate, a radiator, and a ground plane, where the dielectric substrate is disposed between the radiator and the ground plane.

The radiator (or antenna stub) may also include a slot or a slit formed on the conductor, for example, a closed or semi-closed slot or slit formed on a grounded conductor surface. In an embodiment, a radiator with a slot or a slit may be briefly referred to as a slot antenna or a slotted antenna. In an embodiment, a radial size (for example, including a width) of the slot or the slit of the slot antenna/the slotted antenna is far less than a wavelength (for example, a medium wavelength) (for example, is less than 1/16 of the wavelength), and a length size may be compared with the wavelength (for example, the medium wavelength) (for example, the length is approximately 1/8 of the wavelength, or 1/8 to 1/4 of the wavelength, or 1/4 to 1/2 of the wavelength, or greater). In an embodiment, a radiator with a closed slot or slit may be briefly referred to as a closed slot antenna. In an embodiment, a radiator with a semi-closed slot or slit (for example, an opening is additionally provided on the closed slot or slit) may be briefly referred to as an open slot antenna. In some embodiments, the slit is long strip-shaped. In some embodiments, a length of the slit is approximately half the wavelength (for example, the medium wavelength). In some embodiments, a length of the slit is approximately an integer multiple of the wavelength (for example, one medium wavelength). In some embodiments, the slit may be used for feeding through a transmission line bridged on one side or two sides of the slit. In this way, a radio frequency electromagnetic field is excited on the slit, and an electromagnetic wave is radiated to the space. In an embodiment, a radiator of the slot antenna or the slotted antenna may be implemented by a conductive side frame that is grounded at two ends, and may also be referred to as a side frame antenna. In this embodiment, it may be considered that the slot antenna or the slotted antenna includes a linear radiator, and the linear radiator is spaced apart from the ground plane and is grounded at two ends of the radiator, to form a closed or semi-closed slot or slit. In an embodiment, the radiator of the slot antenna or the slotted antenna may be implemented by a bracketed conductor that is grounded at two ends, and may also be referred to as a bracketed antenna.

A feed circuit/feed structure is a combination of all components of an antenna for receiving and transmitting radio frequency waves. In a receive antenna, the feed circuit may be considered as an antenna part from a first amplifier to a front-end transmitter. In a transmit antenna, the feed circuit may be considered as a part after the last power amplifier. In some cases, a "feed circuit" is understood in a narrow sense as a radio frequency chip, or a "feed circuit" includes a transmission path from a radio frequency chip to a radiator or a feed point on a transmission line. The feed circuit has a function of converting a radio wave into an electrical signal and sending the electrical signal to a receiver component. Usually, the feed circuit is considered as a part of the antenna, and is configured to convert a radio wave into an electrical signal, and vice versa. When the antenna is designed, maximum power transmission possibility and efficiency need to be considered. Therefore, a feed impedance of the antenna shall match a load resistance. The feed impedance of the antenna is a combination of a resistance, a capacitance, and an inductance. To ensure a maximum power transmission condition, two impedances (the load resistance and the feed impedance) need to match. The matching can be completed by considering a frequency requirement and a design parameter (for example, a gain, directivity, and radiation efficiency) of the antenna.

Ground/ground plane: The ground/ground plane may generally represent at least a part of any grounding plane, or grounding plate, or grounding metal layer of an electronic device (for example, a mobile phone), or at least a part of any combination of any grounding plane, grounding plate, grounding part, or the like. The "ground/ground plane" may be configured to ground a component of the electronic device. In an embodiment, the "ground/ground plane" may include any one or more of the following: a grounding plane of a circuit board of the electronic device, a grounding plate formed in a middle frame of the electronic device, a grounding metal layer formed by a metal film under a display, a conductive grounding plane of a battery, and a conductive member or a metal member electrically connected to the grounding plane/grounding plate/metal layer. In an embodiment, the circuit board may be a printed circuit board (printed circuit board, PCB), for example, an 8-layer, 10-layer, or 12-layer to 14-layer board with 8, 10, 12, 13, or 14 layers of conductive materials, or an element that is separated and electrically insulated by a dielectric layer or an insulation layer, for example, a glass fiber or a polymer. In an embodiment, the circuit board includes a dielectric substrate, a grounding plane, and a trace layer. The trace layer and the grounding plane are electrically connected through a via. In an embodiment, components such as a display 120, a touchscreen, an input button, a transmitter, a processor, a memory, a battery, a charging circuit, and a system on chip (system on chip, SoC) structure may be mounted on the circuit board or connected to the circuit board, or electrically connected to the trace layer and/or the grounding plane in the circuit board. For example, a radio frequency source is disposed on the trace layer.

Any of the foregoing grounding plane, or grounding plate, or grounding metal layer is made of conductive materials. In an embodiment, the conductive material may be any one of the following materials: copper, aluminum, stainless steel, brass and alloys thereof, copper foil on insulation laminates, aluminum foil on insulation laminates, gold foil on insulation laminates, silver-plated copper, silver-plated copper foil on insulation laminates, silver foil on insulation laminates and tin-plated copper, cloth impregnated with graphite powder, graphite-coated laminates, copper-plated laminates, brass-plated laminates and aluminum-plated laminates. A person skilled in the art may understand that the grounding plane/grounding plate/grounding metal layer may alternatively be made of other conductive materials.

Grounding: The grounding means coupling with the ground/ground plane in any manner. In an embodiment, the grounding may be grounding through an entity, for example, grounding through an entity (or referred to as entity grounding) at a specific position on a side frame is implemented through some mechanical parts of a middle frame. In an embodiment, the grounding may be grounding through a component, for example, grounding through components (or referred to as component grounding) such as capacitors/inductors/resistors connected in series or in parallel.

Resonance frequency: The resonance frequency is also referred to as a resonant frequency. The resonance frequency may have a frequency range, namely, a frequency range in which resonance occurs. The resonance frequency may be a frequency range in which a return loss is less than -6 dB. A frequency corresponding to a strongest resonance point is a center frequency point frequency. A return loss of the center frequency may be less than -20 dB.

Resonance frequency band: A range of a resonance frequency is the resonance frequency band, and a return loss of any frequency on the resonance frequency band may be less than -6 dB or -5 dB.

Communication frequency band/operating frequency band: Regardless of a type of an antenna, the antenna constantly operates in a specific frequency range (a frequency band width). For example, an operating frequency band of an antenna supporting a B40 frequency band includes a frequency in a range of 2300 MHz to 2400 MHz. In other words, the operating frequency band of the antenna includes the B40 frequency band. A frequency range that meets a requirement of an indicator may be considered as an operating frequency band of an antenna. A width of the operating frequency band is referred to as an operating bandwidth. An operating bandwidth of an omnidirectional antenna may reach 3% to 5% of the center frequency. An operating bandwidth of a directional antenna may reach 5% to 10% of the center frequency. The bandwidth may be considered as a range of frequencies on both sides of the center frequency (for example, a resonance frequency of a dipole), where an antenna characteristic is within an acceptable range of values for the center frequency.

The resonance frequency band and the operating frequency band may be the same, or may partially overlap. In an embodiment, one or more resonance frequency bands of the antenna may cover one or more operating frequency bands of the antenna.

Electrical length: The electrical length may be expressed by multiplying a physical length (namely, a mechanical length or a geometric length) by a ratio of a transmission time of an electrical or electromagnetic signal in a medium to a time required by this signal to travel, in free space, for a distance that is the same as the physical length of the medium. The electrical length may satisfy the following formula: $\overline{L} = L \times \frac{a}{b} .$

L is the physical length, a is the transmission time of the electrical or electromagnetic signal in the medium, and b is the transmission time in the free space.

Alternatively, the electrical length may be a ratio of a physical length (namely, a mechanical length or a geometric length) to a wavelength of a transmitted electromagnetic wave. The electrical length may satisfy the following formula: $\overline{L} = \frac{L}{λ} .$

L is the physical length, and λ is the wavelength of the electromagnetic wave.

In some embodiments of this application, a physical length of the radiator may be understood as an electrical length of the radiator within a range of ±20%, ±10%, or ±5%.

Wavelength: The wavelength or an operating wavelength may be a wavelength corresponding to a center frequency of a resonance frequency or a center frequency of an operating frequency band supported by an antenna. For example, it is assumed that a center frequency of a B1 uplink frequency band (with a resonance frequency ranging from 1920 MHz to 1980 MHz) is 1955 MHz. In this case, an operating wavelength may be a wavelength calculated by using the frequency of 1955 MHz. The "operating wavelength" is not limited to the center frequency, and may alternatively be a wavelength corresponding to a non-center frequency of the resonance frequency or the operating frequency band.

It should be understood that a wavelength of a radiation signal in the air may be calculated as follows: (Air wavelength or vacuum wavelength)=Speed of light/Frequency, where the frequency is a frequency (MHz) of the radiation signal, and the speed of light may be 3×10⁸ m/s. The wavelength of the radiation signal in a medium may be calculated as follows: Medium $wavelength = \left(Speed of light/\sqrt{ε}\right) / Frequency$, where ε is a relative dielectric constant of the medium. The wavelength in embodiments of this application is usually a medium wavelength, and may be a medium wavelength corresponding to a center frequency of a resonance frequency, or a medium wavelength corresponding to a center frequency of an operating frequency band supported by an antenna. For example, it is assumed that a center frequency of a B1 uplink frequency band (with a resonance frequency ranging from 1920 MHz to 1980 MHz) is 1955 MHz. In this case, a wavelength may be a medium wavelength calculated by using the frequency of 1955 MHz. The "medium wavelength" is not limited to the center frequency, and may alternatively be a medium wavelength corresponding to a non-center frequency of the resonance frequency or the operating frequency band. For ease of understanding, the medium wavelength mentioned in embodiments of this application may be simply calculated by using a relative dielectric constant of a medium filled in one or more sides of a radiator.

End/point: The "end/point" in a first end/second end/feed end/grounding end/feed point/grounding point/connection point of a radiator of an antenna cannot be understood in a narrow sense as an endpoint or an end portion that is physically disconnected from another radiator, and may also be considered as a point or a segment on a continuous radiator. In an embodiment, the "end/point" may include a connection/coupling area that is on the antenna radiator and that is coupled to another conductive structure. For example, the feed end/feed point may be a coupling area (for example, an area opposite to a part of the feed circuit) that is on the antenna radiator and that is coupled to the feed structure or the feed circuit. For another example, the grounding end/grounding point may be a connection/coupling area that is on the antenna radiator and that is coupled to a ground structure or a ground circuit.

Open end and closed end: In some embodiments, the open end and the closed end are, for example, defined based on whether the end is grounded. The closed end is grounded, and the open end is not grounded. In some embodiments, the open end and the closed end are, for example, defined relative to another conductor. The closed end is electrically connected to the another conductor, and the open end is not electrically connected to the another conductor. In an embodiment, the open end may also be referred to as a floating end, a free end, an opening end, or an open-circuit end. In an embodiment, the closed end may also be referred to as a grounding end or a short-circuit end. It should be understood that, in some embodiments, another conductor may be connected in a coupling manner through the open end, to transfer coupling energy (which may be understood as transferring a current).

In some embodiments, the "open end" may also be understood from a perspective of current distribution. The open end, the floating end, or the like may be understood as a current node on the radiator, or may be understood as an electric field antinode on the radiator. In an embodiment, the open end is coupled to an electronic component (for example, a capacitor or an inductor), so that a current distribution characteristic of the current node/the electric field antinode of the radiator may not be changed.

It should be understood that a radiator end (similar to a radiator at an opening of the open end or the floating end from a perspective of a radiator structure) in a slit is coupled to an electronic component (for example, a capacitor or an inductor), so that the radiator end is a current antinode/electric field node. In this case, it should be understood that the radiator end in the slit is actually a closed end, a grounding end, or the like.

A limitation on a position and a distance, such as middle or a middle position, mentioned in embodiments of this application represents a specific range. For example, the middle (position) of a conductor may be a conductor part including a midpoint on the conductor, or may be a conductor part that includes the midpoint on the conductor and whose length is one-eighth of a wavelength, where the wavelength may be a wavelength corresponding to an operating frequency band of the antenna, and may be a wavelength corresponding to a center frequency of the operating frequency band, or a wavelength corresponding to a resonance point. For another example, the middle (position) of the conductor may be a conductor part that is on the conductor and whose distance from the midpoint is less than a predetermined threshold (for example, 1 mm, 2 mm, or 2.5 mm). A middle position of the slot or a middle position of one side of the slot is a middle position of one side edge of the slot.

Limitations such as collinearity, coaxiality, coplanarity, symmetry (for example, axisymmetricity or centrosymmetry), parallelism, perpendicularity, and sameness (for example, a same length and a same width) mentioned in embodiments of this application are all for a current technology level, but are not absolutely strict definitions in a mathematical sense. A deviation less than a predetermined threshold (for example, 1 mm, 0.5 m, or 0.1 mm) may exist in a width direction between edges of two collinear radiation stubs or two collinear antenna elements. A deviation less than a predetermined threshold may exist between edges of the two coplanar radiation stubs or two coplanar antenna elements in a direction perpendicular to a plane on which two coplanar radiation stubs or two coplanar antenna elements are located. A deviation of a predetermined angle may exist between two antenna elements that are parallel or perpendicular to each other. In an embodiment, the predetermined threshold may be less than or equal to a threshold of 1 mm. For example, the predetermined threshold may be 0.5 mm, or may be 0.1 mm. In an embodiment, the predetermined angle may be an angle within a range of ±10°, for example, a deviation of the predetermined angle is ±5°.

Co-directional/Reverse current distribution mentioned in embodiments of this application should be understood as that main currents on conductors on a same side are co-directional/reverse in direction. For example, when co-directionally distributed currents are excited on a bent conductor or an annular conductor (for example, a current path is also bent or annular), it should be understood that although main currents excited on conductors on two sides of the annular conductor (for example, on conductors around a slit, or on conductors on two sides of a slit) are in reverse directions, the main currents still meet a definition of co-directionally distributed currents in this application. In an embodiment, that currents on a conductor are co-directional may mean that the currents on the conductor have no reverse point. In an embodiment, that currents on a conductor are reverse may mean that the currents on the conductor have at least one reverse point. In an embodiment, that currents on two conductors are co-directional may mean that none of the currents on the two conductors has a reverse point and the currents flow in a same direction. In an embodiment, that currents on two conductors are reverse may mean that none of the currents on the two conductors has a reverse point and the currents flow in reverse directions. That currents on a plurality of conductors are co-directional/reverse may be correspondingly understood.

Antenna gain: The antenna gain represents a degree to which the antenna intensively radiates input power. Usually, a narrower main lobe of an antenna pattern indicates a smaller side lobe, and a higher antenna gain.

System efficiency: The system efficiency is a ratio of power (namely, power that is effectively converted into an electromagnetic wave) radiated by an antenna to space to input power of the antenna. The system efficiency is actual efficiency obtained by matching an antenna port. In other words, the system efficiency of the antenna is actual efficiency (namely, efficiency) of the antenna.

Radiation efficiency: The radiation efficiency is a ratio of power (namely, power that is effectively converted into an electromagnetic wave) radiated by an antenna to space to active power input to the antenna. Active power input to the antenna=Input power of the antenna-Loss power. The loss power mainly includes return loss power and metal ohmic loss power and/or dielectric loss power. A metal loss and a dielectric loss are factors that affect the radiation efficiency.

A person skilled in the art may understand that efficiency is usually indicated by a percentage, and there is a corresponding conversion relationship between the efficiency and dB. Efficiency closer to 0 dB indicates better efficiency of the antenna.

dB: The dB is a decibel, and is a logarithmic concept with ten as the base. The decibel is only used to evaluate a proportional relationship between a physical quantity and another physical quantity, and has no physical size. Each time a ratio between the two quantities increases by 10 times, a difference between the two quantities may be expressed as 10 decibels. For example, if A="100", B="10", C="5", and D="1", A/D=20 dB, B/D=10 dB, C/D=7 dB, and B/C=3 dB. In other words, a difference of 10 decibels between the two quantities indicates that the difference is 10 times, a difference of 20 decibels between the two quantities indicates that the difference is 100 times, and the rest may be deduced by analogy. A difference of 3 dB indicates that the difference between the two quantities is twice.

dBi: The dBi is generally mentioned together with dBd. Herein, dBi and dBd are units of a power gain, and are relative values with different references. The reference for dBi is an omnidirectional antenna, and the reference for dBd is a dipole antenna. Generally, dBi and dBd indicate a same gain. A value indicated by dBi is greater than that indicated by dBd by 2.15 dBi. For example, for an antenna with a gain of 16 dBd, the gain is 18.15 dBi when measured in dBi, and is generally 18 dBi when decimal places are ignored.

Antenna return loss: The antenna return loss may be understood as a ratio of power of a signal reflected back to an antenna port through an antenna circuit to transmit power of the antenna port. A smaller reflected signal indicates a larger signal radiated by the antenna to space and higher radiation efficiency of the antenna. A larger reflected signal indicates a smaller signal radiated by the antenna to space and lower radiation efficiency of the antenna.

The antenna return loss may be represented by an S11 parameter, and S11 is one of S parameters. S11 indicates a reflection coefficient, and the parameter can represent transmit efficiency of the antenna.

In an embodiment, an S11 diagram may be understood as a diagram of resonance generated by the antenna. In an embodiment, a part that is of the resonance shown in the S11 diagram and that is less than -6 dB may be understood as a resonance frequency/a frequency range/an operating frequency band generated by the antenna. The S11 parameter is usually negative. A smaller S11 parameter indicates a smaller antenna return loss, and smaller energy reflected back by the antenna also indicates larger energy actually entering the antenna and higher system efficiency of the antenna. A greater S11 parameter indicates a greater antenna return loss and lower system efficiency of the antenna.

It should be noted that, an S11 value of -6 dB is usually used as a standard in engineering. When an S11 value of the antenna is less than -6 dB, it may be considered that the antenna can operate normally, or it may be considered that transmit efficiency of the antenna is high.

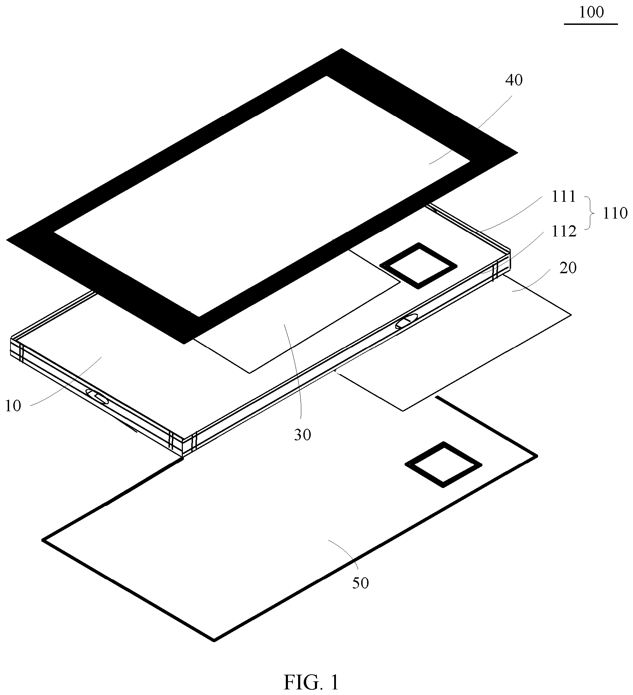

An embodiment of this application provides an electronic device. The electronic device may include devices such as a mobile phone, a tablet computer, a notebook computer, and a smart watch. Refer to FIG. 1. The electronic device 100 includes a side frame 110, a middle frame 10, and a housing. The housing may include a display panel 40 and a back cover 50. The side frame 110 encloses accommodation space, and the middle frame 10 is disposed in the accommodation space. The display panel 40 covers one side (upper part) of the side frame 110, and the back cover 50 covers the other side (lower part) of the side frame 110, to seal the accommodation space. For example, the side frame 110 may be approximately rectangular, the side frame 110 includes a first side frame 111 and a second side frame 112, and a length of the first side frame 111 may be less than a length of the second side frame 112.

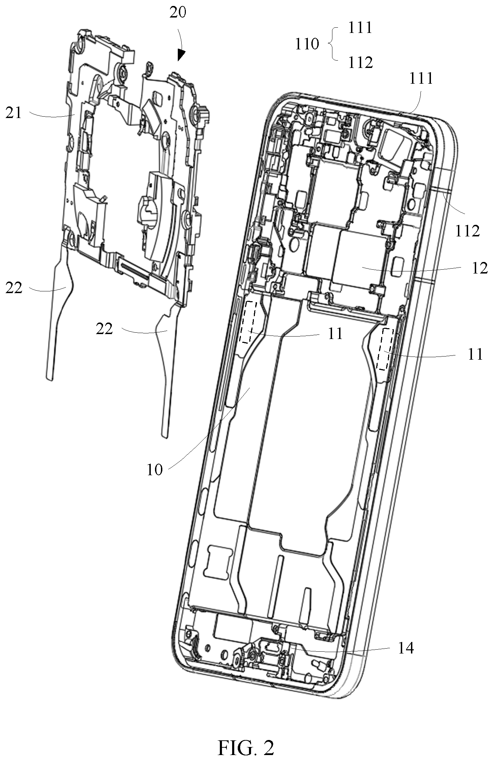

The electronic device 100 further includes a mainboard assembly 20. The mainboard assembly 20 is disposed in the accommodation space, and the mainboard assembly 20 may be disposed on the middle frame 10 to fasten the mainboard assembly 20. Refer to FIG. 2. The mainboard assembly 20 includes a mainboard 21 and a first antenna. The mainboard 21 may include a circuit board, and components such as a processor, a memory, and a radio frequency chip disposed on the circuit board. The first antenna includes a first radiator 22. A feed is disposed on the mainboard 21. The feed may include a radio frequency chip. The feed is coupled to the first radiator 22, so that the first antenna may transmit a signal and/or receive a signal. The first antenna may further include a feed circuit. The feed circuit may include a capacitor and/or an inductor. The radio frequency chip may be coupled to the feed by using the feed circuit, to feed a signal into the first radiator 22. For example, the feed circuit may be disposed on the mainboard 21.

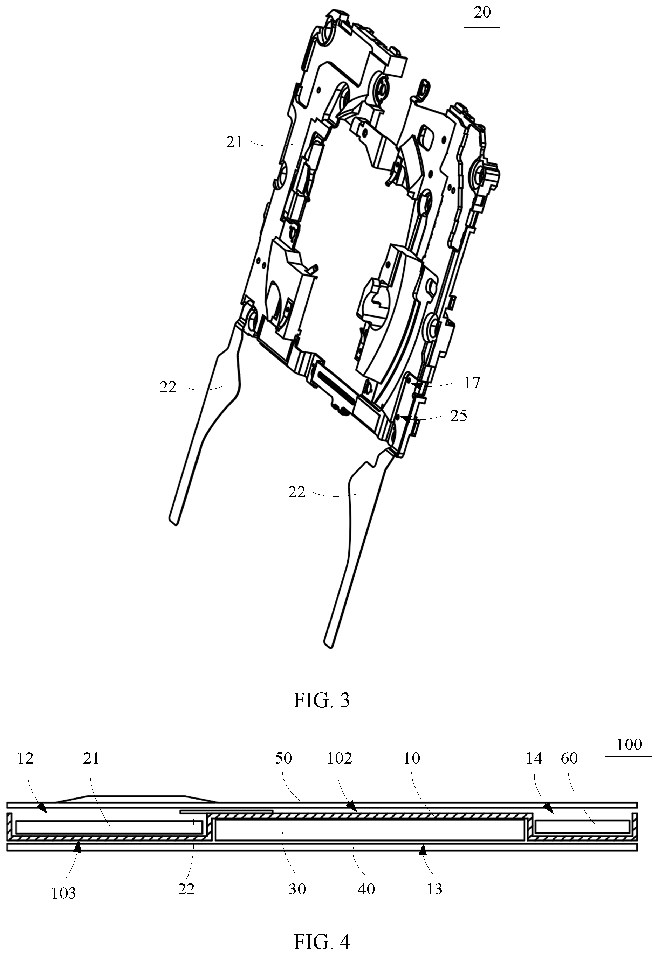

Refer to FIG. 3. For example, an antenna support 25 is disposed on the mainboard 21, the antenna support 25 is an insulation support, and the first radiator 22 may be fastened onto the mainboard 21 by using the antenna support 25. A feed member is disposed on the mainboard 21, and the feed is coupled to the first radiator 22 by using the feed member. In this way, the first radiator may be fed without a complex feeding structure. The feed member may include a structure such as a contact spring and a capacitor, so as to be coupled to and feed (through a coupled signal) the first radiator 22 by using the feed member. In an implementation in which the antenna support 25 is disposed on the mainboard 21, and the feed member may include a conductor (such as a conductive line or a conductive plate) disposed on the antenna support 25, to be coupled to and feed the first radiator 22 by using the feed member.

In some implementations, a positioning pin 17 is disposed on the mainboard 21, and correspondingly, a positioning hole is provided on the first radiator 22, and the positioning pin 17 runs through the positioning hole, to implement positioning of the first radiator 22, and improve location precision of the first radiator 22.

In some embodiments, a bonding layer may be further disposed between the first radiator 22 and the mainboard 21, and the first radiator 22 may be further fastened by using the bonding layer. For example, a recess portion may be disposed on the mainboard 21, and at least a part of the bonding layer is disposed in the recess portion, so that after a part of the first radiator 22 is pasted on the bonding layer, the first radiator 22 may be attached to a surface of the mainboard 21, to reduce a gap between the first radiator 22 and the mainboard and reduce a thickness of the mainboard assembly 20.

In the foregoing embodiment, the first radiator 22 may include a conductor such as a metal plate or a metal pin. A shape of the first radiator 22 is not limited in this embodiment of this application. In some implementations, the mainboard assembly 20 further includes a flexible substrate, the first radiator 22 is disposed on the flexible substrate, and one end of the flexible substrate is connected to the mainboard 21. In this way, the first radiator 22 may be supported by using the flexible substrate. It may be understood that the first radiator 22 has a relatively small thickness, and the flexible substrate may support the first radiator 22, to avoid damage to or deformation of the first radiator 22 in a process of installing and moving the mainboard assembly 20.

For example, the mainboard assembly 20 may include a flexible printed circuit (Flexible Printed Circuit, FPC for short) board. Correspondingly, an insulation layer of the flexible printed circuit board may be used as a flexible substrate, and a conducting layer of the flexible printed circuit board may be used as the first radiator 22.

Refer to FIG. 1 and FIG. 4. In this embodiment of this application, the middle frame 10 may be approximately plate-shaped, the middle frame 10 may be approximately parallel to the display panel 40, the mainboard 21 may cover the middle frame 10, and the mainboard 21 may be connected to the middle frame 10 through a bolt connection, snap-fit connection, or the like.

In the foregoing implementation, the electronic device 100 further includes a battery 30. The battery 30 is disposed in the accommodation space, and the battery 30 may be connected to the middle frame 10 to fasten the battery 30. That at least a part of the middle frame 10 is located between the battery 30 and the first radiator 22 may be understood as that, in a thickness direction (a direction perpendicular to the display panel 40) of the electronic device 100, at least a part of the middle frame 10 is located between the battery 30 and the first radiator 22, and projections of the first radiator 22 and the middle frame 10 on the display panel 40 may partially overlap, or a projection of the first radiator 22 on the display panel 40 is within a projection of the middle frame on the display panel 40, or there is a small interval (for example, the interval is less than or equal to 10 mm) between a projection of the first radiator 22 on the display panel 40 and a projection of the middle frame on the display panel 40. Similarly, projections of the battery 30 and the middle frame 10 on the display panel 40 may partially overlap, or a projection of the battery 30 on the display panel 40 is within the projection of the middle frame on the display panel 40, or there is a small interval (for example, the interval is less than or equal to 10 mm) between a projection of the battery 30 on the display panel 40 and the projection of the middle frame on the display panel 40.

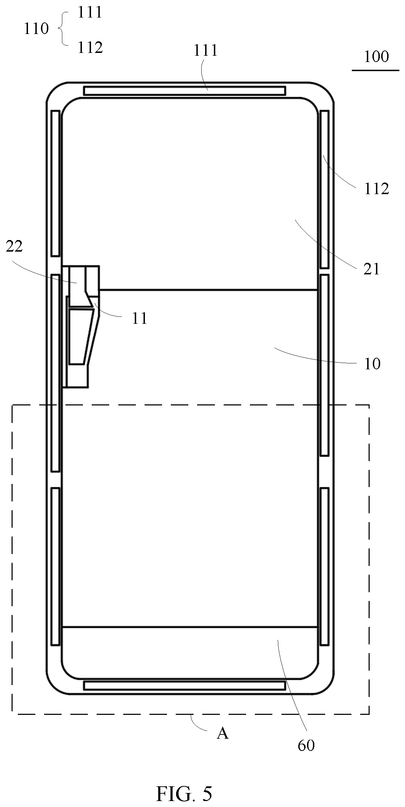

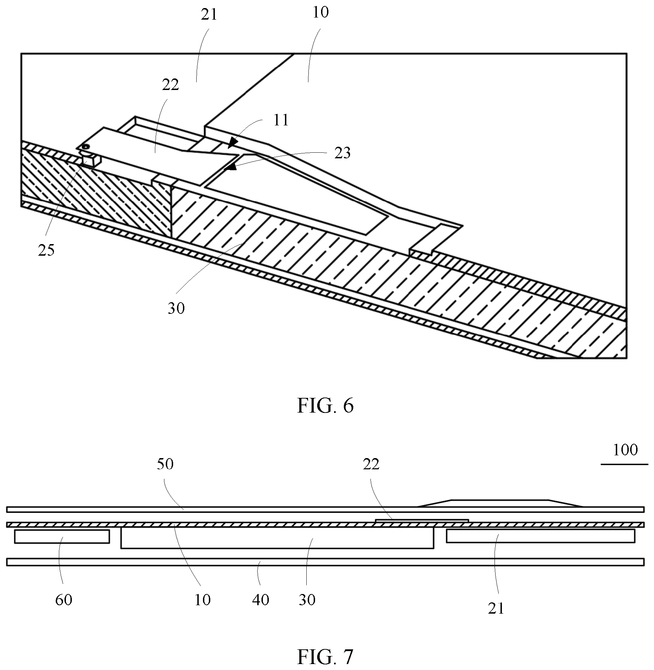

Refer to FIG. 5 and FIG. 6. The middle frame 10 is provided with an opening 11, and the opening 11 runs through the middle frame 10. The first radiator 22 extends along a surface of the mainboard 21, and a part that is of the first radiator 22 and that extends outside the mainboard 21. In other words, the part of the first radiator 22 covers the mainboard 21, and a projection of the other part of the first radiator 22 on the middle frame 10 is outside the projection of the mainboard 21 on the middle frame 10. The part that is of the first radiator 22 and that extends outside the mainboard 21 covers at least a part of the opening 11. It may be understood that a housing of the battery 30 is generally a metal housing, and the housing of the battery 30 is grounded. In other words, the housing of the battery 30 is used as a ground plane of the first antenna, and the housing of the battery 30 assists the first radiator 22 in transmitting a signal through the opening 11. In other words, an area between the battery 30 and the first radiator 22 may provide clearance for the first antenna.

It may be understood that, when the mainboard assembly 20 is not installed on the middle frame 10, the first radiator 22 may have an included angle with the mainboard 21, or may be approximately parallel to the mainboard 21. After the mainboard assembly 20 is installed on the middle frame 10, the first radiator 22 is approximately parallel to the mainboard 21, to cover the opening 11. That the part of the first radiator 22 extends outside the mainboard 21 may be understood as that a projection of the part of the first radiator 22 on a display panel 40 extends outside a projection of the mainboard 21 on the display panel 40.

For example, a projection of the first radiator 22 on the battery 30 may cover a projection of a part of the opening 11 on the battery 30 (the first radiator 22 covers the part of the opening 11); or a projection of the opening 11 on the battery 30 is within a projection of the first radiator 22 on the battery 30 (the first radiator 22 completely covers the opening 11). It may be understood that, properly increasing a projection overlapping area of the first radiator 22 and the opening 11 on the battery 30 (increasing an area that is of the opening 11 and that is covered by the first radiator 22) may increase a gain of the first antenna, thereby improving communication performance.

In this embodiment of this application, the at least a part of the middle frame 10 is disposed between the first radiator 22 and the battery 30, and the first radiator 22 covers at least a part of the opening 11. A surface that is of the first radiator 22 and that is away from the battery 30 may be flush with a surface of the middle frame 10. Alternatively, in a thickness direction of the electronic device, the at least a part of the first radiator 22 is located inside the opening 11.

In this embodiment of this application, the first radiator 22 is located between the opening 11 and an insulation part of the housing, so that the first radiator 22 may radiate a signal through the insulation part of the housing. That the first radiator 22 is located between the opening 11 and the insulation part of the housing may be understood as that, in the thickness direction of the electronic device, the first radiator 22 is located between the opening 11 and the insulation part of the housing. For example, a projection of the insulation part on the display panel 40 and a projection of the first radiator 22 on the display panel 40 may at least partially overlap; or there is a relatively small interval between a projection of the insulation part on the display panel 40 and a projection of the first radiator 22 on the display panel 40.

According to the electronic device 100 provided in this embodiment of this application, at least a part of the middle frame 10 is disposed between the battery 30 and the first radiator 22, the opening 11 is provided in the middle frame 10, and the first radiator 22 covers at least a part of the opening 11. The provided opening 11 provides clearance for the first antenna, or a part of a thickness of the middle frame 10 provides clearance for the first antenna, thereby improving a gain of the first antenna.

In addition, because the opening 11 provides clearance for the first antenna, or a thickness of a part of the middle frame 10 provides clearance for the first antenna, in a case of same antenna performance (for example, a same gain), the middle frame 10 is disposed between the battery 30 and the first radiator 22, so that a thickness (a size perpendicular to a direction of the display panel 40) of the electronic device 100 may be reduced.

Still refer to FIG. 4. In some implementations, the display panel 40 and the back cover 50 are disposed on two sides of the middle frame 10, the mainboard 21 and the first radiator 22 are disposed on a same side of the middle frame 10, the first radiator 22 is located between the middle frame 10 and the back cover 50 (in other words, the mainboard 21 is disposed facing the back cover 50), and the battery 30 is located between the middle frame 10 and the display panel 40 (the battery 30 is disposed facing the display panel 40). In this way, disassembling and maintenance of the mainboard 21 may be implemented by removing the back cover 50, which facilitates disassembling and maintenance of the mainboard 21.

It may be understood that a material of the back cover 50 may include a non-metal material such as ceramic or plastic, to prevent the back cover 50 from blocking signal transmitting and receiving of the first antenna. Certainly, in an implementation in which the material of the back cover 50 includes a metal material, a window may be provided at a position that is on the back cover 50 and that faces the first radiator 22, and an insulation material may be disposed in the window, so that the first antenna may transmit and receive a signal through the window. The projections of the window and the first radiator 22 on the middle frame 10 may at least partially overlap, or there is a relatively small interval (for example, the interval is less than or equal to 10 mm) between the projections of the window and the first radiator 22 on the middle frame 10. In an implementation in which the material of the back cover 50 includes a metal material, the back cover 50 and the middle frame 10 may be an integrated structure.

Refer to FIG. 7. In another implementation, the display panel 40 and the back cover 50 are disposed on two sides of the middle frame 10, the mainboard 21 and the battery 30 are disposed on a same side of the middle frame 10, and the mainboard 21 and the battery 30 may be disposed facing the display panel 40. The first radiator 22 and the mainboard 21 are located on different sides of the middle frame 10. In other words, the first radiator 22 is disposed facing the back cover 50. In this way, disassembling and maintenance of the battery 30 and the mainboard 21 may be implemented by removing the back cover 50, which facilitates disassembling and maintenance of the battery 30 and the mainboard 21.

In another implementation, the mainboard 21 and the first radiator 22 are disposed on a same side of the middle frame 10, the first radiator 22 is located between the middle frame 10 and the display panel 40 (in other words, the mainboard 21 is disposed facing the display panel 40), and the battery 30 is located between the middle frame 10 and the back cover 50 (the battery 30 is disposed facing the back cover 50). In this way, disassembling and maintenance of the battery 30 may be implemented by removing the back cover 50, which facilitates disassembling and maintenance of the battery 30.

It may be understood that an area that is of the display panel 40 and that faces the first radiator 22 may be a window area, and no line may be disposed in the window area, so that the first antenna can receive and transmit a signal through the window area, thereby preventing a line in the window area from blocking a signal. The projections of the window area and the first radiator 22 on the middle frame 10 may at least partially overlap, or there is a relatively small interval (for example, the interval is less than or equal to 10 mm) between the projections of the window area and the first radiator 22 on the middle frame 10.

Still refer to FIG. 4 and FIG. 7. In some embodiments, the middle frame 10 includes a first surface 102 and a second surface 103 that are disposed opposite to each other, and the first surface 102 and the second surface 103 are disposed at an interval in a thickness direction of the middle frame 10. The first surface 102 is provided with a first groove 12, the mainboard 21 is disposed in the first groove 12, the second surface 103 is provided with a second groove 13, the battery 30 is disposed in the second groove 13, and projections of the first groove 12 and the second groove 13 on the middle frame 10 are spaced apart from each other. In this way, the mainboard 21 is disposed in the first groove 12 of the middle frame 10, the battery 30 is disposed in the second groove 13 of the middle frame 10, and at least a part of the first radiator 22 coupled to the feed of the mainboard 21 covers the opening 11 in the middle frame 10. The thickness of the middle frame 10 is used to provide clearance for the antenna, and the radiator of the antenna does not need to be raised inside the housing to obtain clearance, thereby reducing a thickness of the electronic device.

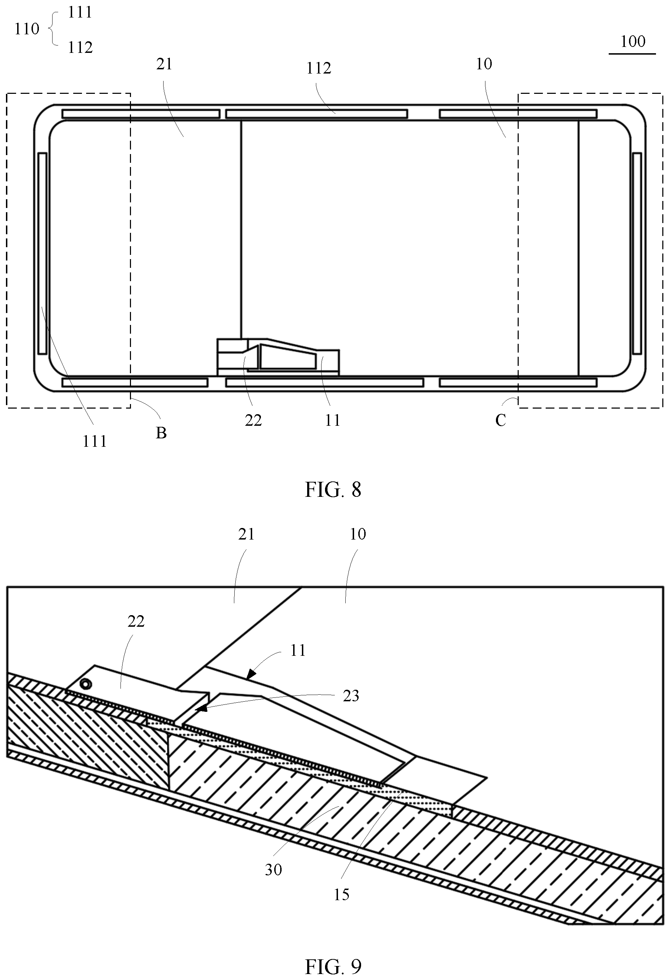

Refer to FIG. 8. In some implementations, a part of the first radiator 22 covers the mainboard 21, and the part of the first radiator 22 is located on a side that is of the mainboard 21 and that is away from the middle frame 10. The other part of the first radiator 22 covers the middle frame 10, so that the part of the first radiator 22 covers at least a part of the opening 11. In other words, the first radiator 22 covers both the mainboard 21 and the middle frame 10, and is located at a boundary position between the battery 30 (as shown in FIG. 4) and the mainboard 21. In an implementation in which the side frame 110 includes the first side frame 111 and the second side frame 112, a length of the first side frame 111 is less than a length of the second side frame 112, and the mainboard 21 and the battery 30 may be arranged in a length direction of the second side frame 112. Because the first radiator 22 is located at a boundary position between the mainboard 21 and the battery 30, the first radiator 22 may be located in a middle area of the length direction (a direction parallel to the second side frame 112) of the electronic device 100 (the middle area is near a midpoint in the length direction of the electronic device, and is within a range of a length of the electronic device on a left and a right of the midpoint in the length direction of the electronic device). When the user holds the electronic device 100 in landscape mode, it is not likely for a hand of the user to block the first radiator 22, to avoid affecting performance of the first antenna (for example, a gain of the first antenna).

It may be understood that the landscape mode may be a scenario in which the user uses a mobile phone to play a game, watch a video, or the like. In the landscape mode, the second side frame 112 is approximately parallel to a horizontal plane, and the user generally holds the first side frame 111, an area B near the first side frame 111, and an area C opposite to the area B. In other words, the user holds two ends of the electronic device 100 in the length direction. However, the first radiator 22 is located at a boundary position between the mainboard 21 and the battery 30, so that the first radiator 22 may be prevented from being blocked in the landscape mode.

Still refer to FIG. 4 and FIG. 5. In some implementations, the electronic device 100 further includes a sub-board 60, where the sub-board 60 is disposed in accommodation space, the sub-board 60 is disposed on the middle frame 10, the mainboard 21, the battery 30, and the sub-board 60 are arranged along the length direction of the second side frame 112, and the battery 30 is located between the mainboard 21 and the sub-board 60. In this way, the first radiator 22 may still be located in the middle area in the length direction of the electronic device 100. When the user holds the electronic device 100 in landscape mode, it is not likely for a hand of the user to block the first radiator 22, to avoid affecting the performance of the first antenna.

Still refer to FIG. 5. For example, in portrait mode (for example, making or receiving a phone call, browsing a web page, or receiving or sending a video), the second side frame 112 is approximately perpendicular to a horizontal plane, the first side frame 111 may be located on the top of the electronic device 100, the mainboard 21 may be disposed close to the first side frame 111, that is, the mainboard 21 is located at an upper part of the electronic device 100, the sub-board 60 is located at a lower part of the electronic device 100, and the first radiator 22 is located at a boundary position between the mainboard 21 and the battery 30, so that the first radiator 22 is located at an upper half of the electronic device 100. However, in the portrait mode, a hand of the user generally holds a lower half (for example, area A) of the electronic device 100, and the hand of the user does not hold the first radiator 22, to prevent the hand of the user from affecting performance of the first antenna.

For example, the sub-board 60 may include a printed circuit board, components such as a speaker and a microphone may be disposed on the sub-board 60, and the sub-board 60 is electrically connected to the mainboard 21, to work under the control of a processor.

In the foregoing implementation, the sub-board 60 and the mainboard 21 may be located on a same side of the middle frame 10. Correspondingly, the first surface 102 of the middle frame 10 is further provided with a third groove 14, and the sub-board 60 is disposed in the third groove 14, to facilitate installation and maintenance of the mainboard 21 and the sub-board 60. Certainly, the sub-board 60 and the battery 30 may alternatively be located on a same side of the middle frame 10. Correspondingly, the third groove 14 may be disposed on the second surface 103 of the mainboard 21, and the sub-board 60 is disposed in the third groove 14.

Refer to FIG. 9. In some embodiments, the electronic device 100 further includes a dielectric layer 15, the opening 11 is filled with the dielectric layer 15, and the first radiator 22 may be attached to a surface of the dielectric layer 15. In this way, the dielectric layer 15 supports the first radiator 22 corresponding to the opening 11, to avoid deformation of the first radiator 22. In an embodiment, a dielectric constant in the opening 11 may be further adjusted by using the dielectric layer, to further adjust performance of the first antenna.

In some implementations, the dielectric layer 15 may be connected (for example, bonded) to the first radiator 22, and the first radiator 22 is fastened to the middle frame 10 by using the dielectric layer 15, to fasten the first radiator 22.

In some embodiments, a gap 23 is provided on the first radiator 22, and the gap 23 truncates the first radiator 22 in a width direction of the first radiator 22. In other words, a part of the first radiator 22 on one side of the gap 23 is coupled to the feed on the mainboard 21, and a part of the first radiator 22 on the other side of the gap 23 covers at least a part of the opening 11. In this way, an electrical length of the first radiator 22 may be adjusted by using the gap 23, to adjust a communication frequency band covered by the first antenna; or a radiation aperture of the first antenna is expanded in a same communication frequency band, to improve radiation efficiency of the first antenna.

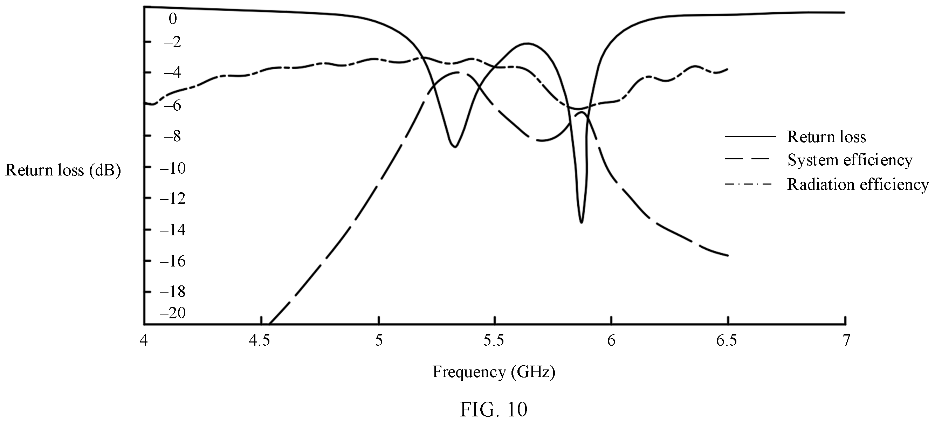

FIG. 10 is a curve diagram of a return loss of the first antenna shown in FIG. 9. Refer to FIG. 10. In this embodiment of this application, the first radiator 22 is configured to generate a first resonance and a second resonance, a resonance frequency of the first resonance is less than a resonance frequency of the second resonance, the resonance frequency of the first resonance may be about 5.3 GHz, and the resonance frequency of the second resonance is 5.8 GHz. In this way, the first radiator 22 is configured to generate two resonances, so that a bandwidth of the first antenna may be increased, thereby improving performance of the first antenna.

For example, the first resonance and the second resonance may cover a same communication frequency band, or the first resonance and the second resonance separately cover different communication frequency bands. This is not limited in this embodiment of this application.

In some implementations, under the first resonance, a current on the first radiator 22 is a co-directional current. Correspondingly, both system efficiency and radiation efficiency of the first antenna are high. A radiation pattern is mainly radiated from a back cover 50 shown in FIG. 1 to a direction away from the display panel 40, and the radiation pattern is approximately hemispherical. Under the second resonance, currents on the first radiator 22 on two sides of the gap 23 are reverse currents. In this case, the first antenna still has specific system efficiency and radiation efficiency, and the radiation pattern is in a lobe shape on a side that is of the back cover 50 shown in FIG. 1 and that is away from the display panel 40 (a main lobe and a side lobe of the radiation pattern are spaced apart from each other along the length direction of the electronic device) and radiates in a direction away from the display panel 40. It may be learned that both the first resonance and the second resonance can meet a communication requirement, so that the first antenna has a large bandwidth.

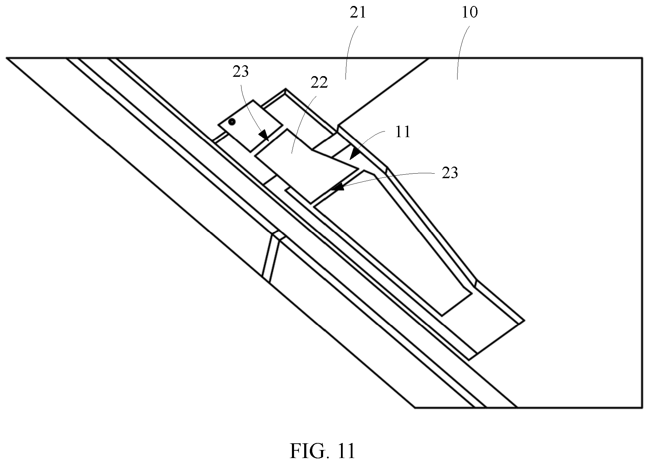

Refer to FIG. 11. In some implementations, there are a plurality of gaps 23 (for example, two, three, or four gaps), and the plurality of gaps 23 are spaced apart in a length direction of the first radiator 22. In this way, the electrical length of the first radiator 22 may be further adjusted. In a case of a same electrical length, a larger quantity of gaps 23 are provided, so that an aperture of the first antenna may be increased, and the radiation efficiency of the first antenna may be improved. In addition, a proper position of the gap 23 may be set to avoid another structure in the electronic device, to prevent the first radiator 22 from affecting disposing and working of the another structure in the electronic device, thereby increasing a degree of freedom of antenna design.

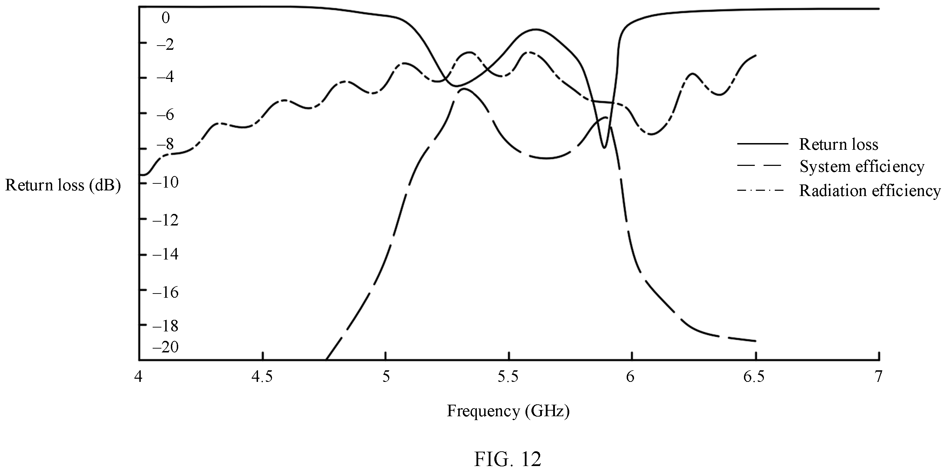

FIG. 12 is a curve diagram of a return loss of the first antenna in an implementation in which the first antenna shown in FIG. 11 has two gaps 23. It may be learned from FIG. 12 that the resonance frequency of the first resonance is about 5.3 GHz, and the resonance frequency of the second resonance is about 5.8 GHz. In addition, under the first resonance, both system efficiency and radiation efficiency of the first antenna are high, and under the second resonance, the first antenna still has specific system efficiency and radiation efficiency. Both the first resonance and the second resonance may meet a communication requirement, so that the first antenna has a large bandwidth.

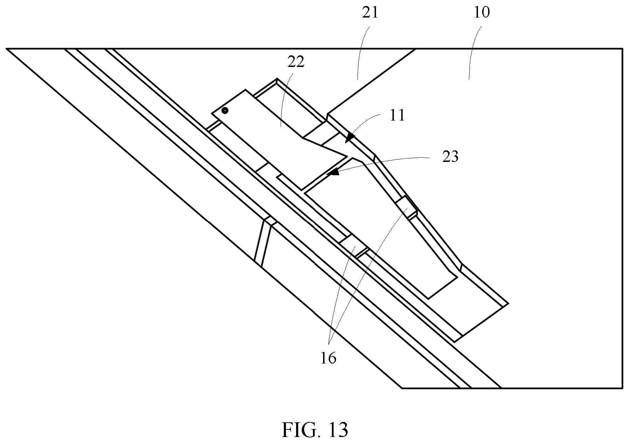

Refer to FIG. 13. In some embodiments, the middle frame 10 further includes a connection rib 16, the connection rib 16 is disposed in the opening 11, and the connection rib 16 may be connected to a side wall of the opening 11. The opening 11 reduces structural strength of the middle frame 10, and disposing the connection rib 16 may improve structural strength of the middle frame 10, thereby avoiding deformation of the middle frame 10. It may be understood that the connection rib 16 is disposed in the opening 11, the connection rib 16 may divide the opening 11 into a first opening and a second opening, and the first opening and the second opening may be arranged roughly along the length direction of the first radiator 22.

The connection rib 16 may be in contact with the first radiator 22; or there is a gap between the connection rib 16 and the first radiator 22, and the gap may also be filled with a dielectric material, so that the connection rib 16 may support the first radiator 22, to avoid deformation of the first radiator 22.

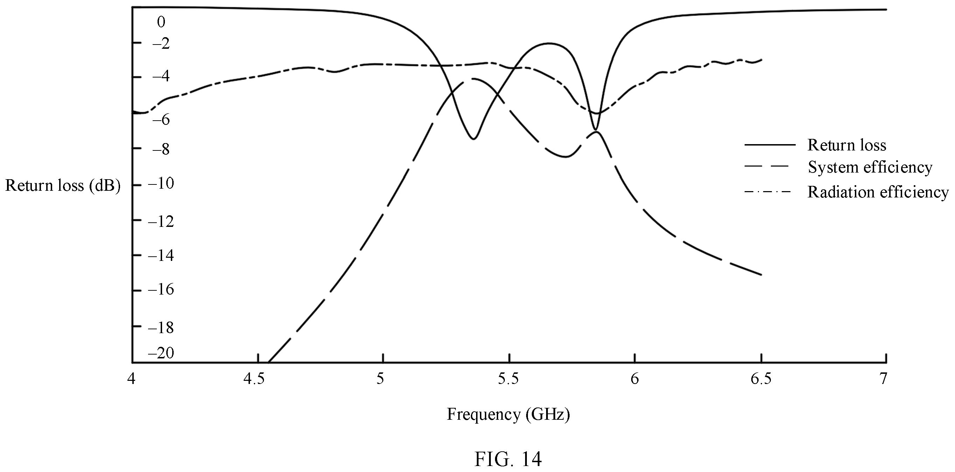

FIG. 14 is a curve diagram of a return loss of the first antenna in an implementation in which the connection rib 16 is disposed for the first antenna shown in FIG. 13. It may be learned from FIG. 14 that the resonance frequency of the first resonance is about 5.3 GHz, and the resonance frequency of the second resonance is about 5.8 GHz. In addition, under the first resonance, both system efficiency and radiation efficiency of the first antenna are high, and under the second resonance, the first antenna still has specific system efficiency and radiation efficiency. Both the first resonance and the second resonance may meet a communication requirement, so that the first antenna has a large bandwidth.

In some implementations, both ends of the first radiator 22 in the length direction are open ends, and in the length direction, a distance between the connection rib 16 and a midpoint of the first radiator 22 is less than or equal to a quarter of a size of the first radiator 22 in the length direction. In this way, the connection rib 16 may correspond to a middle part of the first radiator 22, and the middle part of the first radiator 22 is generally a current antinode. In other words, a current in the middle part is large. Disposing the connection rib 16 in the middle part may reduce impact of the connection rib 16 on the first radiator 22, thereby ensuring that the first antenna has high efficiency.

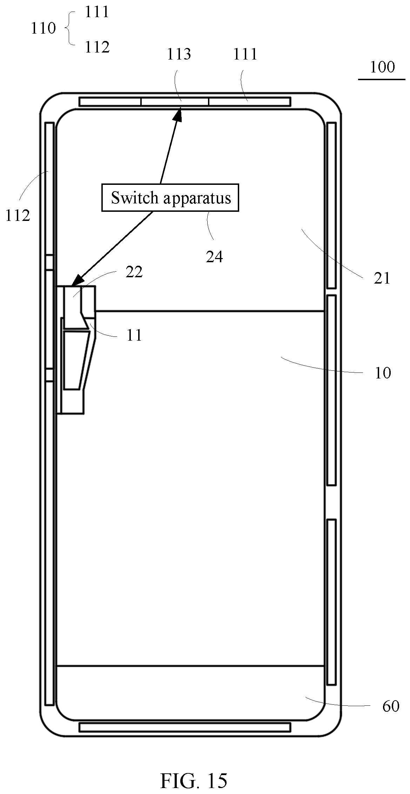

Refer to FIG. 15. In some embodiments, the side frame 110 includes a first side frame 111 and a second side frame 112, and a length of the first side frame 111 is less than a length of the second side frame 112. The electronic device 100 further includes a second antenna and a switch apparatus 24. The second radiator 113 of the second antenna is disposed in the first side frame 111. For example, the second radiator 113 may be disposed to be connected to the first side frame 111 through a bolt connection, snap-fit connection, or the like. Certainly, the second radiator 113 and the first side frame 111 may also be an integrated structure. In other words, a part of the first side frame 111 is used as the second radiator 113. Both the first radiator 22 and the second radiator 113 are coupled to the switch apparatus 24. The switch apparatus 24 may switch a working status of the first antenna and/or a working status of the second antenna. For example, the switch apparatus 24 may enable the first antenna to be in a working state, and enable the second antenna to be in a power-off state (not working), and in this case, the first antenna is used to receive or send a signal; or the switch apparatus 24 may enable the first antenna to be in a power-off state, and enable the second antenna to be in a working state, and in this case, the second antenna is used to receive or send a signal.

For example, a communication frequency band of the first antenna and a communication frequency band of the second antenna may be at least partially the same, and the first antenna and the second antenna may receive or send a same signal. For example, both the first antenna and the second antenna may be configured to receive or send a cellular signal or a Wi-Fi signal. Signals received and sent by the first antenna and the second antenna are not limited in this embodiment of this application.

According to the foregoing disposing, the switch apparatus 24 may select one of the first antenna and the second antenna with better performance to receive or send a signal, to ensure communication quality of the electronic device 100. It may be understood that, in landscape mode, the user holds the electronic device 100 near the first side frame 111, and a hand of the user blocks the second radiator 113. Consequently, signal receiving and sending of the second radiator 113 are affected. In this case, the switch apparatus 24 may control the first antenna to be in a working state, and control the second antenna to be in a power-off state, and the first radiator 22 is used to receive or send a signal, so that relatively good communication quality can be ensured. In the portrait mode, the first side frame 111 generally faces a zenith direction. In this case, the switch apparatus 24 may be used to control the first radiator 22 to be in a power-off state, and control the second radiator 113 to be in a working state, to receive or send a signal by using the second radiator 113, to ensure relatively good communication quality. In other words, it may be ensured that the electronic device 100 has relatively good communication quality in each application scenario.

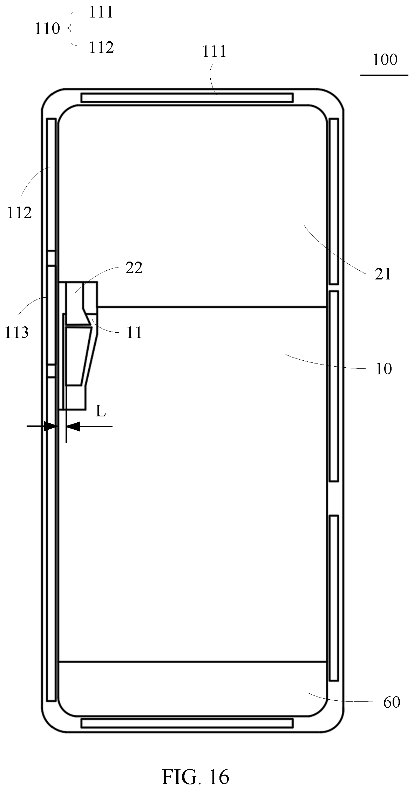

Refer to FIG. 16. In another embodiment, the electronic device 100 further includes a second antenna, and a second radiator 113 of the second antenna is disposed in the second side frame 112. For example, the second radiator 113 may be connected to the second side frame 112 through a bolt connection, snap-fit connection, or the like, or the second radiator 113 and the second side frame 112 are an integrated structure. In other words, a part of the second side frame 112 is used as the second radiator 113. This is not limited in this embodiment of this application.

In some implementations, the second antenna and the first antenna have a same communication frequency band. The first antenna and the second antenna may separately transmit and receive signals, to form a multiple-input multiple-output (Multiple-Input Multiple-Output, MIMO for short) system, thereby improving communication performance. Correspondingly, a minimum distance L between the first radiator 22 and the second radiator 113 is less than or equal to 10 mm (for example, 10 mm, 8 mm, or 5 mm), to ensure compactness of a structure.

In some embodiments, there is a part of the middle frame 10 between the first radiator 22 and the second radiator 113, and the middle frame 10 is generally grounded. The part of the middle frame 10 may improve isolation between the first radiator 22 and the second radiator 113, to ensure antenna radiation efficiency of the first antenna and the second antenna.

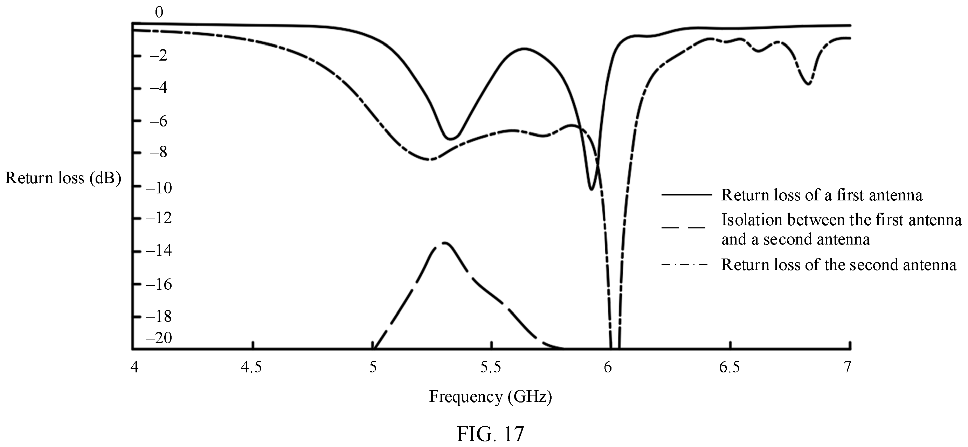

FIG. 17 is a diagram of S-curves for a first antenna and a second antenna shown in FIG. 16. It may be learned from a return loss curve of the first antenna and a return loss curve of the second antenna in FIG. 17 that the first antenna and the second antenna have a same communication frequency band. It may be learned from an isolation curve in FIG. 17 that in the communication frequency band, there is specific isolation between the first antenna and the second antenna, and a communication requirement may be met.

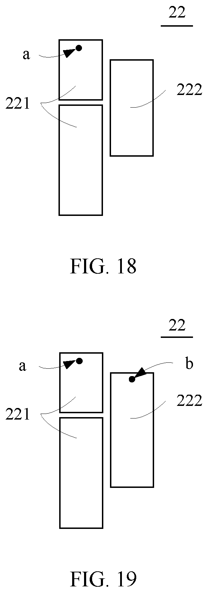

Refer to FIG. 18. In some embodiments, the first radiator 22 includes a first sub-radiator 221 and a second sub-radiator 222. Both the first sub-radiator 221 and the second sub-radiator 222 cover a part of the opening 11 (as shown in FIG. 6). A first feed point a is disposed on the first sub-radiator 221, the first feed point a is configured to receive a signal of a feed, and the first sub-radiator 221 and the second sub-radiator 222 are spaced apart from each other in a direction parallel to the middle frame 10. The first sub-radiator 221 is configured to be coupled to and feed the second sub-radiator 222. In this way, an area of the first radiator 22 may be increased, so that more resonance modes may be formed (for example, a third resonance is formed, and a resonance frequency of the third resonance may be greater than the resonance frequency of the second resonance; or a resonance frequency of the third resonance is less than the resonance frequency of the first resonance), and the bandwidth of the first antenna may be further increased.

For example, a part of the first sub-radiator 221 may cover the mainboard 21, so that the feed on the mainboard 21 may be coupled to the first feed point a, and a part of the first sub-radiator 221 may cover the opening 11. Length directions of the first sub-radiator 221 and the second sub-radiator 222 may be parallel, and the first sub-radiator 221 and the second sub-radiator 222 may be spaced apart from each other in a width direction of the first sub-radiator 221 and the second sub-radiator 222.

Refer to FIG. 19. In another embodiment, the first radiator 22 includes a first sub-radiator 221 and a second sub-radiator 222, the first sub-radiator 221 and the second sub-radiator 222 each cover a part of the opening 11 (as shown in FIG. 6), the first sub-radiator 221 and the second sub-radiator 222 are spaced apart from each other in a direction parallel to the middle frame 10, a first feed point a is disposed on the first sub-radiator 221, a second feed point b is disposed on the second sub-radiator 222, the first sub-radiator 221 is configured to generate a first resonance, the second sub-radiator 222 is configured to generate a second resonance, and a resonance frequency of the first resonance is staggered from a resonance frequency of the second resonance. In this way, different resonances may be formed by using different feed points, so that the bandwidth of the first antenna may be increased, or different communication frequency bands may be covered.

Still refer to FIG. 2. In this embodiment of this application, there may be a plurality of first antennas. Correspondingly, there may be a plurality of first radiators 22, the plurality of first radiators 22 are spaced apart from each other, the middle frame 10 is provided with a plurality of openings 11, each first radiator 22 corresponds to one opening 11, and each first radiator 22 covers at least a part of a corresponding opening 11, to ensure that each first antenna has a high gain.

It may be understood that communication frequency bands corresponding to all first antennas may be the same or may be different. This is not limited in embodiments of this application.

The foregoing descriptions are merely specific implementations of embodiments of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising:
a battery, a middle frame, a housing, and a first antenna, wherein the battery, the middle frame, and the first antenna are disposed in the housing, at least a part of the middle frame is disposed between the battery and a first radiator of the first antenna, an opening is disposed in the middle frame and runs through the middle frame, the first radiator covers at least a part of the opening, and the first radiator is located between the opening and an insulation part of the housing.

2. The electronic device according to claim 1, wherein the electronic device further comprises a mainboard, the middle frame comprises a first surface and a second surface that are disposed opposite to each other, the first surface is provided with a first groove, the mainboard is disposed in the first groove, the second surface is provided with a second groove, the battery is disposed in the second groove, projections of the first groove and the second groove on the middle frame are spaced apart from each other, the mainboard has a feed, and the feed is coupled to the first radiator.

3. The electronic device according to claim 2, wherein a part of the first radiator is located on a side that is of the mainboard and that is away from the middle frame, a feed member is disposed on the mainboard, and the feed is coupled to the first radiator by using the feed member.

4. The electronic device according to claim 2 or 3, wherein the first radiator extends along a surface of the mainboard, and a part that is of the first radiator and that extends outside the mainboard.

5. The electronic device according to any one of claims 1 to 4, wherein the opening is filled with a dielectric layer.

6. The electronic device according to any one of claims 1 to 5, wherein a gap is provided on the first radiator, and the gap truncates the first radiator in a width direction of the first radiator.

7. The electronic device according to claim 6, wherein there are a plurality of gaps, and the plurality of gaps are spaced apart in a length direction of the first radiator.

8. The electronic device according to any one of claims 1 to 7, wherein the middle frame further comprises a connection rib, and the connection rib is disposed in the opening.

9. The electronic device according to claim 8, wherein both ends of the first radiator in the length direction are open ends, and in the length direction, a distance between the connection rib and a midpoint of the radiator is less than or equal to a quarter of a size of the radiator in the length direction.

10. The electronic device according to any one of claims 2 to 9, wherein the electronic device further comprises a side frame, the side frame is disposed around an outer periphery of the middle frame, the side frame comprises a first side frame and a second side frame that are adjacent to each other, the first side frame and the second side frame are disposed vertically, and a length of the first side frame is less than a length of the second side frame; and
the mainboard and the battery are arranged in a length direction of the second side frame.

11. The electronic device according to claim 10, wherein the electronic device further comprises a second antenna and a switch apparatus, a second radiator of the second antenna is disposed in the first side frame, the switch apparatus is coupled to both the first radiator and the second radiator, and the switch apparatus is configured to switch a working status of the first antenna and/or a working status of the second antenna.

12. The electronic device according to claim 10, wherein the electronic device further comprises a second antenna, a second radiator of the second antenna is disposed in the second side frame, and a communication frequency band of the first antenna is at least partially the same as a communication frequency band of the second antenna.

13. The electronic device according to claim 12, wherein a minimum distance between the first radiator and the second radiator is less than or equal to 10 mm.

14. The electronic device according to any one of claims 1 to 13, wherein the first radiator is configured to generate a first resonance and a second resonance, and a resonance frequency of the first resonance is less than a resonance frequency of the second resonance.

15. The electronic device according to claim 14, wherein the first radiator comprises a first sub-radiator and a second sub-radiator, the first sub-radiator and the second sub-radiator each cover a part of the opening, the first sub-radiator and the second sub-radiator are spaced apart from each other in a direction parallel to the middle frame, a first feed point is disposed on the first sub-radiator, and the first sub-radiator is configured to be coupled to and feed the second sub-radiator.

16. The electronic device according to any one of claims 1 to 13, wherein the first radiator comprises a first sub-radiator and a second sub-radiator, the first sub-radiator and the second sub-radiator each cover a part of the opening, the first sub-radiator and the second sub-radiator are spaced apart from each other in a direction parallel to the middle frame, a first feed point is disposed on the first sub-radiator, a second feed point is disposed on the second sub-radiator, the first sub-radiator is configured to generate a first resonance, the second sub-radiator is configured to generate a second resonance, and a resonance frequency of the first resonance is staggered from a resonance frequency of the second resonance.

17. The electronic device according to any one of claims 1 to 16, wherein the housing comprises a display panel and a back cover, and the display panel and the back cover are disposed on two sides of the middle frame; and
the mainboard and the first radiator are both located between the middle frame and the back cover, and the battery is located between the middle frame and the display panel; or
the first radiator is located between the middle frame and the back cover, and the battery and the mainboard are both located between the middle frame and the display panel.

18. A mainboard assembly, comprising:
a mainboard and a first antenna, wherein a feed member is disposed on the mainboard, one end of a first radiator of the first antenna is coupled to the feed member, the feed member is configured to be coupled to and feed the first radiator, the first radiator extends along a surface of the mainboard, and a part that is of the first radiator and that extends outside the mainboard.

19. The mainboard assembly according to claim 18, wherein the part that is of the first radiator and that extends outside the mainboard is configured to cover an opening of a middle frame of an electronic device.

20. The mainboard assembly according to claim 18 or 19, wherein the mainboard assembly further comprises a flexible substrate, the first radiator is disposed on the flexible substrate, and one end of the flexible substrate is connected to the mainboard.
